# EUROPÄISCHE PATENTSCHRIFT

(11) **EP 1 203 447 B1**
(45) Veröffentlichungstag und Bekanntmachung des Hinweises auf die Patenterteilung: **16.06.2004**
(21) Anmeldenummer: 00936629.5
(22) Anmeldetag: 13.04.2000
(51) Int. Cl.: H03G 3/30

(54) **VERFAHREN UND ANORDNUNG ZUM BETRIEB EINES HF-LEISTUNGSVERSTÄRKERS**
METHOD AND DEVICE FOR OPERATING A RADIO FREQUENCY POWER AMPLIFIER
PROCEDE ET DISPOSITIF POUR FAIRE FONCTIONNER UN AMPLIFICATEUR DE PUISSANCE HF

(30) Priorität: 10.08.1999 DE 19937750
(43) Veröffentlichungstag der Anmeldung: 08.05.2002
(73) Patentinhaber: SIEMENS AKTIENGESELLSCHAFT, 80333 München (DE)
(72) Erfinder: BOLLENBECK, Jan, D-80469 München (DE)
(86) Internationale Anmeldenummer: PCT/DE2000/001167
(87) Internationale Veröffentlichungsnummer: WO 2001/011768

(56) Entgegenhaltungen:
- WO-A-98/25339
- US-A- 5 426 641
- SALEH A A M ET AL: "IMPROVING THE POWER-ADDED EFFICIENCY OF FET AMPLIFIERS OPERATING WITH VARYING-ENVELOPE SIGNALS" IEEE TRANSACTIONS ON MICROWAVE THEORY AND TECHNIQUES,US,IEEE INC. NEW YORK, Bd. 31, Nr. 1, 1983, Seiten 51-56, XP000601707 ISSN: 0018-9480

## Beschreibung

Die Erfindung betrifft ein Verfahren zum Betrieb eines HF-Leistungsverstärkers, insbesondere einer Mobilfunk-Sendeendstufe, nach dem Oberbegriff des Anspruchs 1 sowie eine Anordnung zur Durchführung dieses Verfahrens.

Die mobile Sprach- und Datenkommunikation ist ein sich extrem schnell entwickelndes technisches Gebiet mit sehr großer wirtschaftlicher Perspektive. Die Nutzung dieser Perspektive setzt die ständig verbesserte Ausnutzung der verfügbaren Frequenzressourcen und die Erschließung von Möglichkeiten zur Übertragung immer größerer Datenmengen mit der erforderlichen Zuverlässigkeit voraus.

Bei der Festlegung neuer Standards, die diesen Anforderungen Rechnung tragen müssen, wird - anders als beispielsweise noch beim aktuellen GSM-Standard - der Einsatz von Modulationsverfahren mit nicht konstanter Hüllkurve, d.h. z.B. von kombinierten Phasen- und Amplitudenmodulationsverfahren, festgelegt. So ist im Rahmen des die nähere Zukunft der Mobiltechnik bestimmenden UMTS(Universal Mobile Telecommunication System)-Standards der Einsatz der QPSK(Quadrature Phase Shift Keying)-Modulation als Beispiel eines solchen Modulationsverfahrens vorgesehen.

Die Verstärkung von derart modulierten HF-Signalen - beispielsweise in der Sendeendstufe eines Mobilfunk-Endgerätes - muß mit hoher Genauigkeit verzerrungsfrei, d.h. frei von Amplitudenverzerrungen infolge von Nichtlinearitäten der Verstärkerkennlinie sowie frei von Phasenverzerrungen erfolgen, die durch den Vorgang der "AM-to-PM-Conversion" hervorgerufen werden. Die in den Mobilfunkstandards der Zukunft, beispielsweise dem erwähnten UMTS-Standard, definierten digitalen Modulationsverfahren reagieren nämlich äußerst empfindlich auf verzerrungsbedingte Bitfehler. In den Systemstandards bzw. - spezifikationen sind daher strenge Vorschriften bezüglich der zulässigen Amplituden- und Phasenfehler sowie der zulässigen Nachbarkanalleistung (ACP = Adjacent Channel Power) enthalten.

Die in den Spezifikationen festgelegten Fehlergrenzen und Nachbarkanalleistungen können nur mit hochgradig linear arbeitenden Sendeverstärkern oder durch Einsatz zusätzlicher Entzerrungsschaltungen zur Linearisierung der Übertragungskennlinie eingehalten werden. Der lineare Betrieb eines Klasse-A-Verstärkers setzt voraus, daß der 1dB-Ausgangskompressionspunkt des Verstärkers deutlich oberhalb des Spitzenleistungspegels des Ausgangssignals liegt. Diese Anforderung ist bei der Auslegung sämtlicher Verstärkerstufen und Bias-Ströme zu berücksichtigen. Bei einer solchen Auslegung des Verstärkers für die maximal bereitzustellende Ausgangsleistung ergibt sich bei kleinen Leistungspegeln eine unnötig hohe Stromaufnahme. Der Wirkungsgrad des Verstärkers sinkt also mit abnehmendem Ausgangsleistungspegel schnell ab. Dies stellt einen ernst zu nehmenden Gebrauchswertnachteil für den Benutzer dar, weil er eine unnötig hohe Stromaufnahme und damit relativ kurze Ladezyklen für den Akku des Mobilfunk-Endgerätes mit sich bringt. Dies ist besonders gravierend bei künftigen Geräten nach dem UMTS-Standard, weil bei diesen der Sender im sogenannten Vollduplex-Betrieb kontinuierlich betrieben wird.

An zusätzlichen Maßnahmen zur Linearisierung der Übertragungskennlinie einer - für sich genommen - nichtlinearen Verstärkeranordnung ist beispielsweise eine Vorverzerrung des modulierten Signals bekannt, mit der die nichtlineare Übertragungskennlinie des eigentlichen Verstärkers invers nachgebildet wird, so daß aus der Überlagerung der realen Ubertragungskennlinie des Verstärkers und des invers nachgebildeten Amplitudenganges des modulierten Signals sich insgesamt eine annähernd lineare Übertragungsfunktion ergibt. Diese Maßnahme ist, wie andere Maßnahmen ähnlicher Art auch, jedoch in der elektronischen Realisierung relativ aufwendig und ermöglicht eine wirkliche Linearisierung der Gesamt-Übertragungskennlinie nur bis zu einem gewissen Grade.

Aus der Praxis der Anmelderin ist es weiterhin bekannt, mit dem Ziel der Linearisierung einer Verstärkerkennlinie die Stromaufnahme einzelner Transistorstufen mit einer von der erwarteten Ausgangsleistung abhängigen Sollgröße zu vergleichen und die Transistorarbeitspunkte in Abhängigkeit vom Vergleichsergebnis nachzuführen.

Zur Unterdrückung eines unerwünschten Nebeneffektes von Nichtlinearitäten der Verstärkerkennlinie des Sendeverstärkers - nämlich der Aufweitung des Sendefrequenzsspektrums durch Intermodulationseffekte (hauptsächlich dritter Ordnung) - ist es weiterhin bekannt, durch einen Vergleich von Ein- und Ausgangssignal und durch geeignete Amplituden- und Phaseneinstellung am Ausgang des Vergleichers die Intermodulationsprodukte als Fehlersignal aus dem Gesamtsignal abzutrennen. Das so gewonnene Fehlersignal kann dann zur Erzielung einer Intermodulations-Gegenkopplung über geeignete Koppelelemente auf den Eingang des zu linearisierenden Verstärkers (oder zur Realisierung einer Vorwärtskopplung auf dessen Ausgang) gegeben werden. Dies ist jedoch eine zusätzliche Maßnahme, die lediglich eine Auswirkung der erwähnten Nichtlinearitäten minimieren kann.

Es ist daher Aufgabe der Erfindung, ein wirkungsvolles Verfahren zum Betrieb eines HF-Leistungsverstärkers mit annähernd linearer Kennlinie sowie eine entsprechende Schaltungsanordnung anzugeben, die mit vertretbarem Aufwand realisierbar sind.

Diese Aufgabe wird hinsichtlich ihres Verfahrensaspektes durch ein Verfahren mit den Merkmalen des Anspruchs 1 und hinsichtlich ihres Vorrichtungsaspektes durch eine Anordnung mit den Merkmalen des Anspruchs 6 gelöst.

Die Erfindung schließt nach einem Aspekt den wesentlichen Gedanken ein, den Kollektor- oder Drainstrom der Transistoren bzw. Stufen des HF-Leistungsverstärkers auf einen Mindestwert einzustellen, der die Erfüllung der geltenden Linearitätsanforderungen gewährleistet. Weiter schließt sie den Gedanken ein, den Ausgangssignalpegel über eine Variation des Eingangssignalpegels zu steuern. Schließlich gehört zur Erfindung der wesentliche Gedanke, als Bewertungskriterium den Quotienten aus der Oberwellen- und Nutzsignalleistung des Ausgangssignals heranzuziehen.

Mit dem hier vorgeschlagenen Prinzip läßt sich, unabhängig von der bereitzustellenden Ausgangsleistung, permanent ein auf einen hohen Wirkungsgrad optimierter Arbeitspunkt des HF-Leistungsverstärkers beibehalten. Hierdurch kann die Stromaufnahme speziell bei geringer Aussteuerung deutlich reduziert und damit beispielsweise die Ladezykluszeit für die Akkus eines Mobiltelefons spürbar verlängert werden.

In einer bevorzugten Ausführung dieser vorgeschlagenen Lösung wird die Steuerung des Eingangssignalpegels als "klassische" Leistungsregelung mittels einer Regelschleife ausgeführt.

In einer anderen vorteilhaften Ausführung wird die Steuerung des Eingangssignalpegels durch eine spezielle Steuereinheit unter Zugriff auf eine tabellenartig gespeicherte Zuordnungsvorschrift zwischen Verstärkungs- bzw. Ausgangssignalpegelwerten und Eingangssignalpegelwerten ausgeführt. Eine solche Realisierung setzt das Vorhandensein entsprechender Speicher- und Verarbeitungsmittel voraus, ist aber bei einem mikroprozessorgesteuerten Gerät wie einem Mobiltelefon ohne weiteres möglich.

In einer speziellen Ausbildung kann die erwähnte Steuerung des Eingangssignalpegels auch aufgrund von Steuersignalen erfolgen, die dem Sendegerät von außen zugeführt werden - beispielsweise im Rahmen des "Downlink Closed Loop Power Control" nach dem UMTS-Standard, wobei dem Mobiltelefon periodisch durch die Basisstation ein Befehl zur Einstellung des Sendeleistungspegels (Absenkung oder Erhöhung um einen bestimmten Betrag oder Faktor) übermittelt wird.

Der Vorgang der Änderung des Eingangssignalpegels kann insbesondere als Variation der Dämpfung eines dem Verstärkereingang vorgelagerten Dämpfungsgliedes ablaufen.

Zur Bias- bzw. Kollektor-/Drainstrom-Einstellung dient in vorteilhafter Weise eine von der erwähnten Leistungsregelschleife getrennte Regelschleife.

Vorteile und Zweckmäßigkeiten der Erfindung ergeben sich im übrigen aus den Unteransprüchen sowie der nachfolgenden Beschreibung bevorzugter Ausführungsbeispiele anhand der Figuren. Von diesen zeigen:
- Fig. 1: eine schematische Darstellung zur Erläuterung einer ersten Ausführungsform der Erfindung in Form eines Funktions-Blockschaltbildes und
- Fig. 2: eine schematische Darstellung zur Erläuterung einer zweiten nicht erfindungsgemäßen Ausführungsform in Form eines Funktions-Blockschaltbildes.

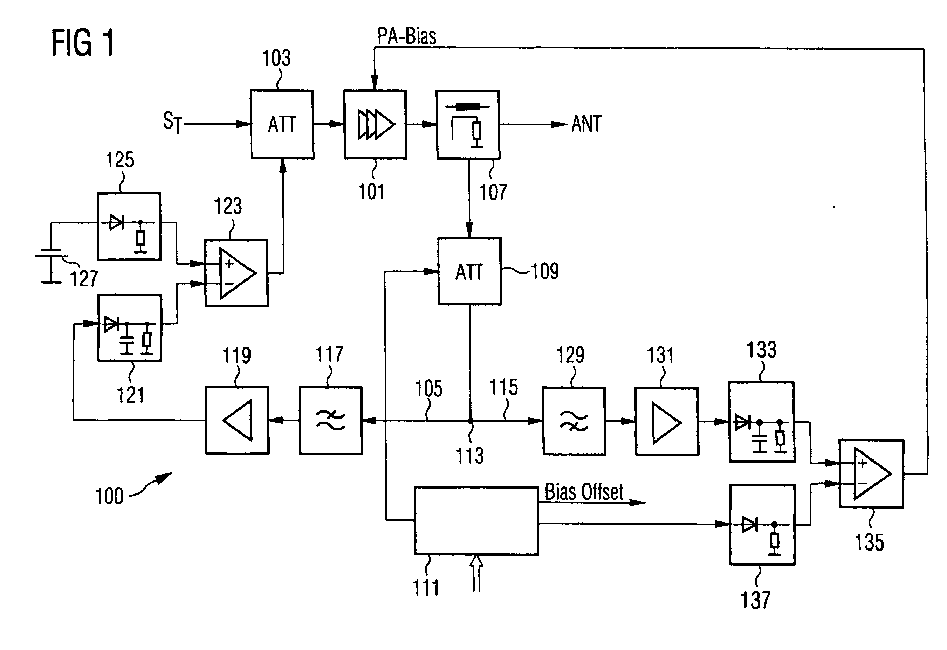

Fig. 1 zeigt eine Sendeverstärkeranordnung 100 gemäß einem ersten Ausführungsbeispiel, deren Kernstück ein HF-Leistungsverstärker 101 ist, welcher im Hinblick auf eine QPSK-Modulation eines Sendesignals S_{T} hohen Linearitätsandforderungen genügen muß.

Dem HF-Leistungsverstärker 101 ist ein steuerbares Dämpfungsglied 103 vorgeschaltet, das zur Einstellung des Eingangssignalpegels des HF-Leistungsverstärkers 101 über eine Leistungsregelschleife 105 angesteuert wird. Dem HF-Leistungsverstärker 101 ist ein Richtkoppler 107 nachgeschaltet, der einen Teil der Verstärker-Ausgangsleistung auf dem Signalweg zu einer Antenne ANT auskoppelt und einem weiteren steuerbaren Dämpfungsglied 109 zuführt. Dessen Dämpfung wird über eine Steuereinheit 111 eingestellt, die weiter unten genauer erläutert wird. Nach Durchlaufen des Dämpfungsgliedes 109 gelangt der ausgekoppelte Teil des Verstärker-Ausgangssignals zu einem Knoten 113, der einen Verzweigungspunkt zwischen der oben bereits erwähnten Leistungsregelschleife 105 und einer Bias-Regelschleife 115 bildet.

In der Leistungs-Regelschleife 105 ist dem Knotenpunkt 113 (optional) ein Tiefpaß 117 und diesem ein linearer Kleinsignalverstärker 119 nachgeordnet. Mit dem Ausgang des Kleinsignal- bzw. Linearverstärkers 119 ist ein Leistungsdetektor 121 verbunden, dessen Ausgang mit dem invertierenden Eingang eines als Regelverstärker wirkenden Operationsverstärkers 123 verbunden ist. Mit dem nicht-invertierenden Eingang des Operationsverstärkers 123 ist ein Temperaturkompensationselement 125 verbunden, dessen Eingang mit einer Referenzspannungsquelle 127 verbunden ist. Das Ausgangssignal des Operationsverstärkers 123 bildet das Steuersignal zur Einstellung der variablen Dämpfung des Dämpfungsgliedes 103.

In der Bias-Regelschleife 115 ist dem Knotenpunkt 113 ein Hochpaß 129 und diesem ein Linearverstärker 131 nachgeschaltet, dessen Ausgang mit einem Leistungsdetektor 133 verbunden ist. Dessen Ausgang ist mit dem nichtinvertierenden Eingang eines Operationsverstärkers (Regelverstärkers) 135 verbunden, dessen invertierender Eingang mit einem weiteren Temperaturkompensationsglied 137 verbunden ist. Dieses erhält von der Steuereinheit 111 eine Bias-Offsetspannung, die - analog zur Gewinnung des Steuersignals für das variable Dämpfungsglied 109 - aus einer in der Steuereinheit 111 gespeicherten tabellarischen Zuordnung zwischen Bias-Offsetwerten (bzw. Dämpfungswerten für die Einstellung des Dämpfungsgliedes) und einzustellenden Ausgangssignalpegeln abgeleitet wird.

Aufgrund der Leistungsregelung liegt am Knotenpunkt 113 stets ein Signal mit (abgesehen von der Hüllkurvenschwankung infolge der Amplitudenmodulation des Ausgangssignals) konstantem Nutzleistungspegel an. Die durch anschließende Hochpaßfilterung im Filter 129 gewonnene Oberwellenleistung dieses Signals wird nach linearer Verstärkung einer Leistungserfassung unterzogen, in deren Ergebnis eine Ist-Spannung erhalten wird, welche mit einer in der Steuereinheit 111 erzeugten Soll-Spannung verglichen wird. Über das im Ergebnis des Vergleiches gewonnene Steuersignal (das Ausgangssignal des Regelverstärkers 135) wird der Arbeitspunkt des HF-Leistungsverstärkers 101 so eingeregelt, daß dieser mit hinreichend linearer Kennlinie arbeitet.

Über die Steuereinheit 111 kann ein Ruhestrom (bzw. Kollektor- bzw. Drainstrom) eingestellt werden, der auch bei kleiner Aussteuerung des HF-Leistungsverstärkers nicht unterschritten werden kann. Bei der in der Figur dargestellten Ausführung greift diese Steuergröße "Bias-Offset" in der Regelschleife an, in einer alternativen Ausführung kann sie aber auch direkt dem Leistungsverstärker zugeführt werden. Bei der Auslegung der Bias-Regelschleife muß auf eine den Systemanforderungen genügende Bandbreite geachtet werden.

Das Verhältnis zwischen Oberwellen- und Nutzsignalleistung (das direkt die Linearität des HF-Leistungsverstärkers 101 kennzeichnet) wird über die Regelschleife 105 dynamisch in Abhängigkeit von der jeweils eingestellten Ausgangsleistung den in den Systemspezifikationen vorgegebenen Anforderungen angepaßt.

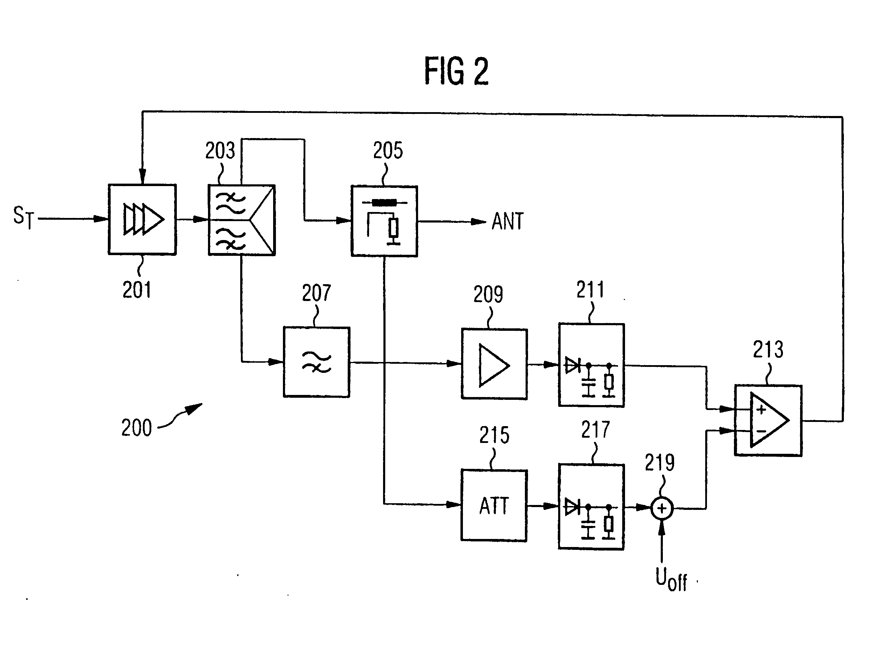

In Fig. 2 ist eine Sendeverstärkeranordnung 200 in einer modifizierten Ausführung beschrieben, die einen von einer Leistungsregelung unabhängigen Betrieb einer Endstufen-Bias-Regelung ermöglicht. Ein HF-Leistungsverstärker 201 wird hier wieder mit einem QPSK-modulierten Sendesignal S_{T} gespeist, und das verstärkte Ausgangssignal wird einem Diplexer 203 zugeführt, dem im Signalweg zu einer Antenne ANT wiederum ein Richtkoppler 205 nachgeschaltet ist. Der Diplexer 203 wirkt hier als Oberwellenfilter für das Ausgangssignal und ermöglicht eine konstante Impetanzanpassung des Verstärkerausgangs für Frequenzen weit oberhalb der Nutzfrequenz, weitgehend unabhängig vom Abschlußwiderstand am zweiten Ausgangsanschluß des Diplexers.

Über diesen zweiten Ausgangsanschluß ist der Diplexer 203 über einen Hochpaß 207 mit dem Eingang eines Linearverstärkers 209 verbunden, dessen Ausgangssignal einem Leistungsdetektor 211 zugeführt wird, der den Oberwellenleistungsanteil des Ausgangssignals des HF-Leistungsverstärkers 201 ermittelt. Das Ausgangssignal des Leistungsdetektors 211 wird dem nicht-invertierenden Eingang eines Operationsverstärkers (Regelverstärkers) 213 zugeführt, dessen Ausgangssignal das Steuersignal zur Steuerung des HF-Leistungsverstärkers 201 bildet.

Dem invertierenden Eingang des Operationsverstärkers 213 wird ein primär durch den Richtkoppler 205 abgezweigter Signalanteil des oberwellenbedämpften Nutzsignals zugeführt, der über ein Dämpfungsglied 215 zu einem weiteren Leistungsdetektor 217 gelangt, welcher den Nutzleistungsanteil des Gesamt-Ausgangssignals des HF-Verstärkers 201 ermittelt. Dem Leistungsdetektor 217 ist ein Summierer 219 nachgeschaltet, dem eine (beispielsweise wieder einer Zuordnungstabelle entnommene) Offsetspannung U_{off} zur Anpassung des Oberwellenabstandes zugeführt werden kann.

Das Verhältnis der Oberwellen- zur Nutzleistung, das nach obigem als Bewertungskriterium zur Verstärkereinstellung dient, wird bei dieser Anordnung über das Verhältnis der Verstärkung der Komponentenketten Diplexer 203 - Richtkoppler 205 - Dämpfungsglied 215 - Leistungsdetektor 217 (Nutzsignalleistung) bzw. Diplexer 203 - Hochpaß 207 - Linearverstärker 209 - Leistungsdetektor 211 (Oberwellenleistung) bestimmt.

In einer gegenüber Fig. 2 modifizierten Ausführung wird auf den Summierer 219 verzichtet und statt dessen das Dämpfungsglied 215 als steuerbares Dämpfungsglied ausgeführt, dessen Dämpfung über eine Steuerspannung (entsprechend U_{off}) verändert werden kann. Hierbei werden die Leistungsdetektoren 211, 217 stets im gleichen DC- und HF-Arbeitspunkt betrieben.

## Patentansprüche

1. Verfahren zum Betrieb eines HF-Leistungsverstärkers (100), insbesondere einer Mobilfunk-Sendeendstufe, mit annähernd linearer Kennlinie unter Einstellung mindestens eines Betriebsparameters des Verstärkers oder mindestens eines aktiven Bauelements desselben,
**dadurch gekennzeichnet, daß**
ein minimaler Kollektor- oder Drainstrom des aktiven Bauelements bzw. einer Verstärkerstufe des HF-Leistungsverstärkers über eine Bias-Regelschleife (115) und der Eingangssignalpegel des HF-Leistungsverstärkers über eine Leistungs-Regelschleife (105) in Abhängigkeit vom Quotienten aus Oberwellen- und Nutzsignalleistung des Verstärker-Ausgangssignals gesteuert wird.

2. Verfahren nach Anspruch 1,
**dadurch gekennzeichnet, daß**
die Steuerung des Eingangssignalpegels (S_{T}) als Leistungsregelung mittels einer Regelschleife (105) ausgeführt wird.

3. Verfahren nach Anspruch 1,
**dadurch gekennzeichnet, daß**
die Steuerung des Eingangssignalpegels unter Zugriff auf eine, insbesondere in Art eines Lookup-Table gespeicherte Zuordnungsvorschrift zwischen Verstärkungs- bzw. Ausgangssignalpegelwerten und Eingangssignalpegelwerten durch eine Eingangspegel-Steuereinheit ausgeführt wird.

4. Verfahren nach Anspruch 3,
**dadurch gekennzeichnet, daß**
die Eingangspegel-Steuereinheit aufgrund von extern übermittelten Verstärkungs- oder Ausgangssignalpegelwerten oder Verstärkungs- oder Ausgangssignal-Änderungsbefehlen arbeitet.

5. Verfahren nach einem der vorangehenden Ansprüche,
**dadurch gekennzeichnet, daß**
zur Steuerung des Eingangssignalpegels die Dämpfung eines vorgeschalteten Dämpfungsgliedes (103) und/oder die Verstärkung eines vorgeschalteten Kleinsignalverstärkers variiert wird.

6. HF-Leistungsverstärkeranordnung (100), insbesondere Mobilfunk-Sendeendstufe, mit annähernd linearer Kennlinie,
**gekennzeichnet durch**
Bias-Einstellmittel (115) zur Einstellung eines minimalen Kollektor- oder Drainstromes mindestens eines aktiven Bauelements oder einer Verstärkerstufe der HF-Leistungsverstärkeranordnung und
Eingangssignalpegel-Einstellmittel (105) zur Einstellung des Eingangssignalpegels,
jeweils in Abhängigkeit vom Quotienten aus Oberwellen- und Nutzsignalleistung des Verstärker-Ausgangssignals.

7. HF-Leistungsverstärkeranordnung nach Anspruch 5,
**dadurch gekennzeichnet, daß**
die Bias-Einstellmittel eine Bias-Regelschleife (115) und die Eingangssignalpegeleinstellmittel eine von der Bias-Regelschleife im wesentlichen getrennte Leistungsregelschleife (105) umfassen.

8. HF-Leistungsverstärkeranordnung nach Anspruch 6,
**dadurch gekennzeichnet, daß**
die Eingangssignalpegel-Einstellmittel eine Eingangssignalpegel-Steuereinheit (111) mit einer Speichereinheit aufweisen, in der, insbesondere in Art eines Lookup-Table eine Zuordnungsvorschrift zwischen Verstärkungs- bzw. Ausgangssignalpegelwerten und Eingangssignalpegelwerten gespeichert ist.

9. HF-Leistungsverstärkeranordnung nach einem der Ansprüche 6 bis 8,
**dadurch gekennzeichnet, daß**
die Eingangssignalpegel-Einstellmittel ein steuerbares Dämpfungsglied (103) oder einen steuerbaren linearen Kleinsignalverstärker aufweisen.

10. HF-Leistungsverstärkeranordnung nach einem der Ansprüche 6 bis 9,
**dadurch gekennzeichnet, daß**
die Bias-Einstellmittel ein Hochpaßfilter (129) und einen diesem mindestens mittelbar nachgeschalteten ersten Leistungsdetektor (133) und die Eingangssignalpegel-Einstellmittel ein Tiefpaßfilter (117) und einen diesem mindestens mittelbar nachgeordneten zweiten Leistungsdetektor (121) aufweisen.

11. HF-Leistungsverstärkeranordnung nach einem der Ansprüche 6 bis 10,
**dadurch gekennzeichnet, daß**
die Bias-Einstellmittel (115) und die Eingangssignalpegel-Einstellmittel (105) jeweils ein Temperaturkompensationselement (125, 137) aufweisen.

12. HF-Leistungsverstärkeranordnung nach einem der Ansprüche 6 bis 11,
**dadurch gekennzeichnet, daß**
die Bias-Einstellmittel (115) und/oder die Eingangssignalpegel-Einstellmittel (105) Bezugswert-Bereitstellungsmittel (111, 127) sowie über einen Eingang mit diesen verbundene Vergleicher- oder Subtraktionsmittel (123, 135) aufweisen.

## Claims

1. Method for operating an RF power amplifier (100), particularly a mobile radio transmitting output stage, with an approximately linear characteristic by adjusting at least one operating parameter of the amplifier or at least one active component of this amplifier, **characterized in that** a minimum collector or drain current of the active component or, respectively, an amplifier stage of the RF power amplifier is controlled by means of a bias control loop (115) and the input signal level of the RF power amplifier is controlled by means of a power control loop (105) in dependence on the quotient of harmonic power and useful-signal power of the amplifier output signal.

2. Method according to Claim 1, **characterized in that** the input signal level (S_{T}) is controlled as power control by means of a control loop (105).

3. Method according to Claim 1, **characterized in that** the input signal level is controlled with access to an allocation rule, stored in the form of a look-up table, in particular, between amplification or output signal level values and input signal level values by an input level control unit.

4. Method according to Claim 3, **characterized in that** the input level control unit operates on the basis of externally transmitted amplification or output signal level values or amplification or output signal change commands.

5. Method according to one of the preceding claims, **characterized in that** the attenuation of a preceding attenuation section (103) and/or the amplification of a preceding small-signal amplifier is/are varied for controlling the input signal level.

6. RF power amplifier arrangement (100), particularly a mobile radio transmitting output stage with an approximately linear characteristic, **characterized by** bias adjusting means (115) for adjusting a minimum collector or drain current of at least one active component or of an amplifier stage of the RF power amplifier arrangement and input signal level adjusting means (105) for adjusting the input signal level, in each case in dependence on the quotient of harmonic power and useful-signal power of the amplifier output signal.

7. RF power amplifier arrangement according to Claim 5, **characterized in that** the bias adjusting means comprise a bias control loop (115) and the input signal level adjusting means comprise a power control loop (105) which is essentially separate from the bias control loop.

8. RF power amplifier arrangement according to Claim 6, **characterized in that** the input signal level adjusting means exhibit an input signal level control unit (111) with a storage unit in which an allocation rule between amplification or output signal level values and input signal level values is stored, particularly in the form of a look-up table.

9. RF power amplifier arrangement according to one of Claims 6 to 8, **characterized in that** the input signal level adjusting means exhibit a controllable attenuation section (103) or a controllable linear small-signal amplifier.

10. RF power amplifier arrangement according to one of Claims 6 to 9, **characterized in that** the bias adjusting means exhibit a high-pass filter (129) and a first power detector (133), which follows the filter at least indirectly, and the input signal level adjusting means exhibit a low-pass filter (117) and a second power detector (121), which follows this filter at least indirectly.

11. RF power amplifier arrangement according to one of Claims 6 to 10, **characterized in that** the bias adjusting means (115) and the input signal level adjusting means (105) in each case exhibit a temperature compensation element (125, 137).

12. RF power amplifier arrangement according to one of Claims 6 to 11, **characterized in that** the bias adjusting means (115) and/or the input signal level adjusting means (105) exhibit reference value providing means (111, 127) and comparator or subtraction means (123, 135) which are connected to the latter via an input.

## Revendications

1. Procédé pour faire fonctionner un amplificateur de puissance H.F. (100), en particulier un étage final d'émission de radiocommunication mobile, à caractéristique approximativement linéaire, par réglage d'au moins un paramètre de fonctionnement de l'amplificateur ou d'au moins un composant actif de celui-ci,
**caractérisé en ce que**
un courant minimal de collecteur ou de drain du composant actif resp. d'un étage amplificateur de l'amplificateur de puissance H.F. est commandé par l'intermédiaire d'une boucle de réglage de prétension (115) et le niveau de signal d'entrée de l'amplificateur de puissance H.F. par l'intermédiaire d'une boucle de réglage de puissance (105), en fonction du quotient de la puissance des harmoniques par la puissance du signal utile du signal de sortie de l'amplificateur.

2. Procédé selon la revendication 1,
**caractérisé en ce que**
la commande du niveau de signal d'entrée (S_{T}) en tant que régulation de puissance est réalisée au moyen d'une boucle de réglage (105).

3. Procédé selon la revendication 1,
**caractérisé en ce que**
la commande du niveau de signal d'entrée, par accès à une instruction d'affectation stockée notamment à la manière d'une table look-up entre valeurs d'amplification resp. de niveau de signal de sortie et valeurs de niveau de signal d'entrée, est réalisée par une unité de commande du niveau d'entrée.

4. Procédé selon la revendication 3,
**caractérisé en ce que**
l'unité de commande du niveau d'entrée fonctionne sur la base de valeurs d'amplification ou de niveau de signal de sortie ou d'instructions de modification de l'amplification ou du signal de sortie, transmises de l'extérieur.

5. Procédé selon l'une des revendications précédentes,
**caractérisé en ce que**
pour commander le niveau de signal d'entrée, on fait varier l'affaiblissement d'un affaiblisseur (103) monté en amont et/ou l'amplification d'un amplificateur petit signal monté en amont.

6. Dispositif amplificateur de puissance H.F. (100), en particulier étage final d'émission de radiocommunication mobile, à caractéristique approximativement linéaire,
**caractérisé par**
des moyens de réglage de prétension (115) pour régler un courant minimal de collecteur ou de drain d'au moins un composant actif ou d'un étage amplificateur du dispositif amplificateur de puissance H.F. et
des moyens de réglage du niveau de signal d'entrée (105) pour régler le niveau de signal d'entrée,
en fonction à chaque fois du quotient de la puissance des harmoniques par la puissance du signal utile du signal de sortie de l'amplificateur.

7. Dispositif amplificateur de puissance H.F. selon la revendication 5,
**caractérisé en ce que**
les moyens de réglage de prétension comprennent une boucle de réglage de prétension (115) et les moyens de réglage du niveau de signal d'entrée une boucle de réglage de puissance (105) essentiellement séparée de la boucle de réglage de prétension.

8. Dispositif amplificateur de puissance H.F. selon la revendication 6,
**caractérisé en ce que** les moyens de réglage du niveau de signal d'entrée comprennent une unité de commande du niveau de signal d'entrée (111) avec une unité de mémoire dans laquelle est stockée, notamment à la manière d'une table look-up, une instruction d'affectation entre valeurs d'amplification resp. de niveau de signal de sortie et valeurs de niveau de signal d'entrée.

9. Dispositif amplificateur de puissance H.F. selon l'une des revendications 6 à 8,
**caractérisé en ce que**
les moyens de réglage du niveau de signal d'entrée comprennent un affaiblisseur (103) commandable ou un amplificateur petit signal linéaire commandable.

10. Dispositif amplificateur de puissance H.F. selon l'une des revendications 6 à 9,
**caractérisé en ce que**
les moyens de réglage de prétension comprennent un filtre passe-haut (129) et, monté au moins indirectement en aval de celui-ci, un premier détecteur de puissance (133), et les moyens de réglage du niveau de signal d'entrée comprennent un filtre passe-bas (117) et, monté au moins indirectement en aval de celui-ci, un deuxième détecteur de puissance (121).

11. Dispositif amplificateur de puissance H.F. selon l'une des revendications 6 à 10,
**caractérisé en ce que**
les moyens de réglage de prétension (115) et les moyens de réglage du niveau de signal d'entrée (105) comprennent à chaque fois un élément de compensation thermique (125, 137).

12. Dispositif amplificateur de puissance H.F. selon l'une des revendications 6 à 11,
**caractérisé en ce que**
les moyens de réglage de prétension (115) et/ou les moyens de réglage du niveau de signal d'entrée (105) comprennent des moyens de mise à disposition de valeurs de référence (111, 127) ainsi que, reliés à ceux-ci par une entrée, des comparateurs ou soustracteurs (123, 135).
